# EUROPEAN PATENT SPECIFICATION

(11) **EP 0 687 750 B1**
(45) Date of publication and mention of the grant of the patent: **26.07.2000**
(21) Application number: 95303112.7
(22) Date of filing: 09.05.1995
(51) Int. Cl.: C23C 18/12, C30B 5/00

(54) **Method for manufacturing thin film of composite metal-oxide dielectric**
Verfahren zur Herstellung eines Dünnfilms eines Verbund-Metalloxid-Dielektrikums
Procédé de fabrication d'un film mince d'un oxyde composite diélectrique

(30) Priority: 16.06.1994 JP 13402694
(43) Date of publication of application: 20.12.1995
(73) Proprietor: SHARP KABUSHIKI KAISHA, Osaka-shi, Osaka-fu 545-0013 (JP)
(72) Inventor: Masuda, Yoshiyuki, Noda-shi, Chiba-ken (JP); Kita, Ryusuke, Matsudo-shi, Chiba-ken (JP); Arai, Hisako, Kashiwa-shi, Chiba-ken (JP); Ohtani, Noboru, Katsushika-ku, Tokyo (JP); Koba, Masayoshi, Kashiwa-shi, Chiba-ken (JP)
(74) Representative: West, Alan Harry

(56) References cited:
- EP-A- 0 375 594
- EP-A- 0 489 519
- EP-A- 0 650 187
- EP-A- 0 653 784
- EP-A- 0 674 019
- EP-A- 0 678 598
- THIRD EURO-CERAMICS, vol.2, 12 September 1993, SPAIN pages 685 - 698 HIRANO 'processing of better ferroelectric films through chemistry'
- VIJAY & DESU: "", J. ELECTROCHEMICAL SOC., , , vol. 140, no. 9, pages 2640 to 2645
- HIRANO ET AL.: "", J. AM. CERAM. SOC., , , vol. 75, no. 6, pages 1697 to 1700
- HIRANO & KATO: "", BULL. CHEM. SOC. JAPAN, , , vol. 62, no. 2, pages 429 to 434
- HIRANO ET AL.: "", J. AM. CERAM. SOC., , , vol. 75, no. 10, pages 2785 to 2789

## Description

The present invention relates to a method for manufacturing a thin film of barium strontium titanate dielectric which is suitable for use in memory devices, pyroelectric devices, piezoelectric devices and electrooptic devices.

Composite metallic oxide dielectrics generally find application through their electrical characteristics in the field of electronics. For example, composite metal-oxide dielectrics are used in various kinds of devices such as infrared linear array sensors using their pyroelectric property, supersonic sensors using their piezoelectric property, waveguide type optical modulators using their electrooptic effects, and capacitors for DRAMs and NMICS (Microwave Monolithic IC) using their high dielectric property.

In particular, the area of a large capacity capacitor may be reduced by using a material having a high dielectric constant, in an integrated circuit (IC), such as GaAsMMIC.

For thin film materials having such a high dielectric constant, there are used composite metal-oxide dielectrics such as SrTiO₃ (strontium titanate), BST (barium strontium titanate) and PLZT (lead lanthanum zirconate titanane). BST has been vigorously researched as a most promising material. For practical use in various semiconductor elements, a thin film of this metal-oxide dielectric is desirably manufactured at a low temperature to improve its temperature characteristics. Such manufacture uses a physical method such as vacuum evaporation, sputtering or laser ablation or a chemical procedure such as the sol-gel method or CVD (Chemical Vapor Deposition) method. The sol-gel method uses organometal raw materials and the thin film of metal-oxide dielectric is obtained by thermal decomposition.

The sol-gel method is widely used since the raw materials can be uniformly mixed at an atomic level and the dielectric thin film can be manufactured on an industrial basis at low cost.

In a general procedure for manufacturing a BST thin film by the sol-gel method, organometal compounds, such as alkoxides of barium, strontium and titanium, are mixed in a suitable solvent such as ethanol, propanol, butanol, methoxyethanol or acetic acid. Thereafter, the following sequence of steps is followed.
(1) The organometal compounds are heated and stirred in an inert gas atmosphere of nitrogen, for example, to prepare a precursor sol solution of composite alkoxide having a two-dimensional chain structure of the formula (I). 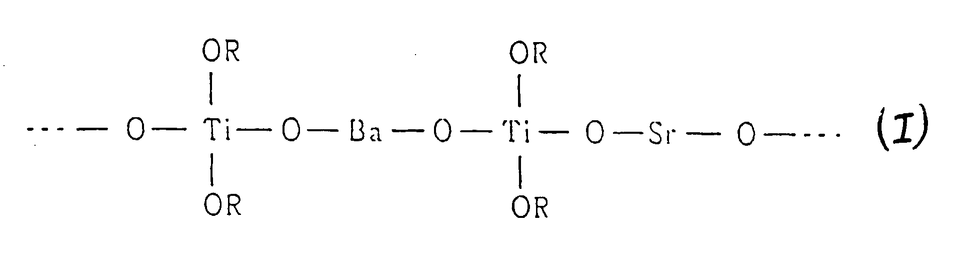
(2) This sol (the precursor solution) is then applied to a substrate so as to form a thin film by spin coating or dip coating, for example. The sol of the two-dimensional chain structure is thereby hydrolyzed by moisture in the air and becomes a gel having a three-dimensional network structure of the formula (II) by subsequent condensation polymerization. 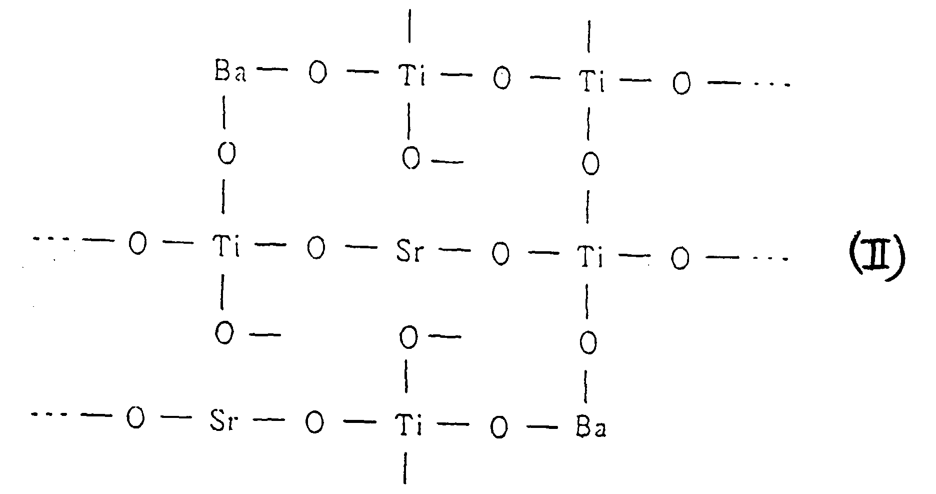
(3) The gel formed as a film is heated and dried to separate from the film the alcohol produced and the residual moisture not absorbed into the network structure.
(4) The film is then subjected to heat treatment at 350 to 450°C to convert this gel film into an amorphous form by thermally decomposing and removing organic components in the film.
(5) The film is finally subjected to another heat treatment at 650 to 750°C to crystallize this film.

Steps (2) to (4) are repeated plural times before step (5) to obtain a thin film of a BST dielectric having the desired thickness.

However, it is necessary to set the film forming temperature at or below 600°C for maintaining transistor characteristics in a Hetero-junction Bipolar Transistor (HBT) structure for use in GaAsMMICs.

In this general method for thin film metal-oxide dielectric manufacture, it is difficult to provide a single orientation for the thin film in steps (4) and (5), i. e., by carrying out the crystallization heat treatment after converting the thin film into an amorphous state. The thin film is therefore orientated at random. Further, for obtaining a high dielectric constant, it is necessary to heat the thin film at 650 to 750°C for crystallization, as in step (5).

Variations of the basic sol-gel technique have been described in numerous publications. For example, the formation of lead zirconate titanate (PZT) ferroelectric thin films having a perovskite structure has been described in J. Electrochem. Soc. 140, 9 (1993) 26 40; EP-A-0489519; EP-A-0653784. EP-A-0650187; EP-A-0674019; and J. Am. Ceram. Soc. 75, 10 (1992) 2785, the formation of lithium niobate thin films has been described in EP-A-0678598 and Bull. Chem. Soc. Japan 62, 2 (1989) 429, the latter describing also the formation of lithium tantalate thin films; and the formation of strontium barium niobate thin films having orthorhombic or tetragonal phases has been described in J. Am. Ceram. Soc. 75, 6 (1992) 1697. EP-A-0375594 does, in fact, describe the manufacture of, inter alia, BST by a variation of the sol-gel method by mixing aqueous barium acetate with ethanolic titanium ethoxide and strontium-2,4-pentanedione to form a celloid gel, air drying a film coating and firing at 800°C.

The present invention seeks to provide a method for manufacturing a thin film of BST dielectric having a high dielecric constant, even at low temperatures.

According to the present invention there is provide a method for manufacturing a thin film of a barium strontium titanate dielectric having a single orientation, the method comprising the steps of:
(a) preparing a precursor solution in a sol state containing component elements of materials of the barium strontium titanate;
(b) forming a thin film in a sol state from the precursor solution;
(c) drying the thin film in the sol state by removing residual moisture to form a thin film of dry gel;
(d) subjecting the dry gel thin film obtained in step (c) to a heat treatment at 500°C to 600°C thereby to thermally decompose and remove organic substances within the thin film in the gel state and simultaneously crystallise the dry gel thin film; and
(e) repeating steps (b) to (d) thereby to obtain a thin film of barium strontium titanate dielectric having a desired thickness and a single (111) orientation.

The precursor solution preferably contains barium diethoxide, strontium diethoxide and titanium tetraisopropoxide as components.

In accordance with the present invention, the thin film BST dielectric is manufactured by the sol-gel method but in which the heat treatment step for thermally decomposing and removing the organic substances from the dry gel thin film serves for simultaneously crystallizing the dry gel thin film. Accordingly, the thin film can be crystallized at a low temperature. This makes it possible to manufacture the thin film of BST dielectric having a single orientation and a high dielectric constant.

The present invention is described below in greater detail by way of example only with reference to the accompanying drawings, in which
Fig. 1 is a cross-sectional view showing the construction of the dielectric thin film element of BST manufactured in accordance with one embodiment of the present invention;
Fig. 2 is a flow chart showing manufacturing processes in accordance with one embodiment of the present invention;
Fig. 3 is a view showing an X-ray diffraction pattern of the thin film of BST dielectric;
Fig. 4 is a view showing measured results of the dielectric constant of the thin film of BST dielectric in each of this embodiment and Comparison Examples 1 and 2;
Fig. 5 is a flow chart showing a comparative method for manufacturing the thin film BST dielectric;
Fig. 6 is a view showing an X-ray diffraction pattern of the thin film BST dielectric in Comparison Example 1; and
Fig. 7 is a view showing an X-ray diffraction pattern of the thin film BST dielectric in Comparison Example 2.

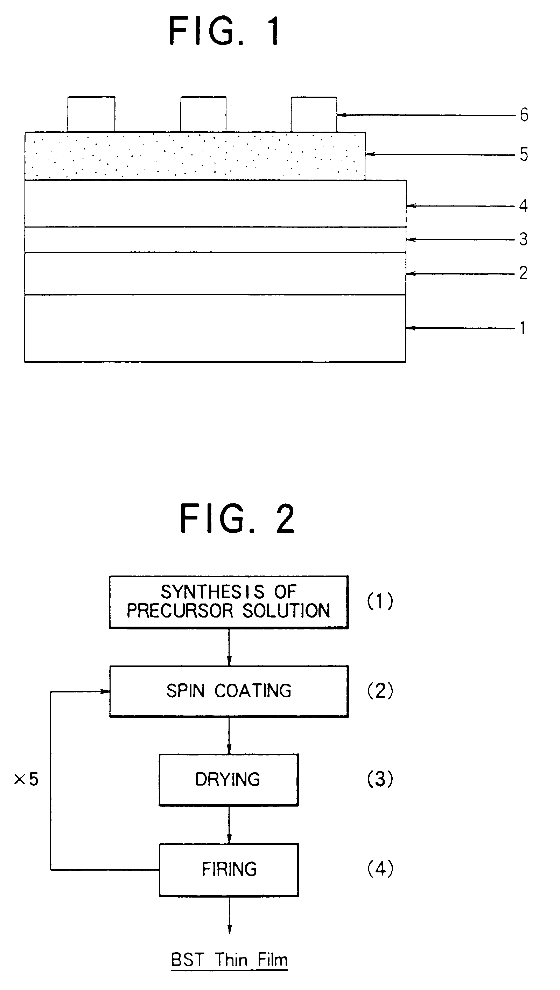

Referring to the drawings, Fig. 1 is a cross-sectional view showing the structure of a thin film element of a composite BST dielectric manufactured in accordance with one embodiment of the present invention. As shown in Fig. 1, a thermally grown silicon dioxide film 2 200 nm thick is formed on the surface of an n-type silicon substrate 1. A titanium (Ti) film 3 30 nm thick, a platinum (Pt) film 4 200 nm thick, a (Ba_{0.7}Sr_{0.3})TiO₃ thin film 5 200 nm thick and a platinum (Pt) upper electrode 6 100 nm thick are sequentially formed on the thermally grown silicon dioxide film 2. The (Ba_{0.7}Sr_{0.3})TiO₃ thin film 5 is referred to as a BST thin film in the following description. The thermally grown silicon dioxide film 2 is formed as an insulating film constituting a passivation layer. This insulating film is not limited to the thermally grown silicon dioxide film 2. The platinum film 4 is used as a non-oxidizable film since an oxide film is formed on this platinum film 4. The titanium film 3 is used to ensure close contact with the thermally grown silicon dioxide film 2 and the platinum film 4. A tantalum (Ta) film or a TiN film, for example may be used instead of this titanium film 3.

The manufacture of the thin film element of composite BST dielectric shown in Fig. 1 is carried out as follows.

First, the thermally grown silicon dioxide film 2 200 nm thick is formed on the surface of an n-type silicon substrate 1. In this embodiment, the thermally grown silicon dioxide film 2 is formed by thermally oxidizing the surface of the silicon substrate 1 at a temperature of 1000°C. A titanium (Ti) film 3 30 nm thick is formed on this silicon dioxide film 2 by a sputtering method. Further, a platinum (Pt) film 4 200 nm thick and (111) in orientation is formed on this titanium film 3. The structure obtained is used as a substrate.

Processes for forming a BST thin film dielectric on the platinum film 4 of this substrate will now be explained with reference to the flow chart shown in Fig. 2.

In step 1, a sol of a composite alkoxide having a two-dimensional chain structure is prepared as a precursor solution by heating and stirring barium diethoxide (Ba (OC₂H₅)₂), strontium diethoxide (Sr(OC₂H₅)₂) and titanium tetra-isopropoxide (Ti(OCH(CH₃)₂)₄) in isopropanol. In this embodiment, acetylacetone as a stabilizing agent is added to the precursor solution. Methoxyethanol or acetic acid can be used as a solvent for the precursor solution.

In step 2, this precursor solution is dropped onto the substrate and is sequentially spin-coated by being rotated for for three seconds at 200 rpm and then for 20 seconds at 2000 rpm. The precursor solution is formed into a thin film by this spin coating process, and the surface area of two precursor solution in a sol state is greatly increased.

Accordingly, the sol of the precursor solution is hydrolyzed by moisture in the air during and after this spin coating process, becoming a gel having a three-dimensional network structure by condensation polymerization.

Next, in step 3, the film is dried by subjecting it to a heat treatment for 10 minutes at a temperature of 100°C to separate the alcohol produced in the reaction and the residual moisture unabsorbed into the network structure from the film, so that a dry gel is obtained. In step 4, a film of the obtained dry gel is fired by subjecting it to heat treatment for 30 minutes at a temperature of 550°C at atmospheric pressure to thermally decompose the organic substances in the dry gel film and simultaneously crystallize the dry gel film.

Steps 2 to 4 are repeated so that the thin film of metal-oxide dielectric having a predetermined thickness can be obtained. In this embodiment, steps 2 to 4 are repeated five times so that a BST thin film 5 having 200 nm thickness can be obtained.

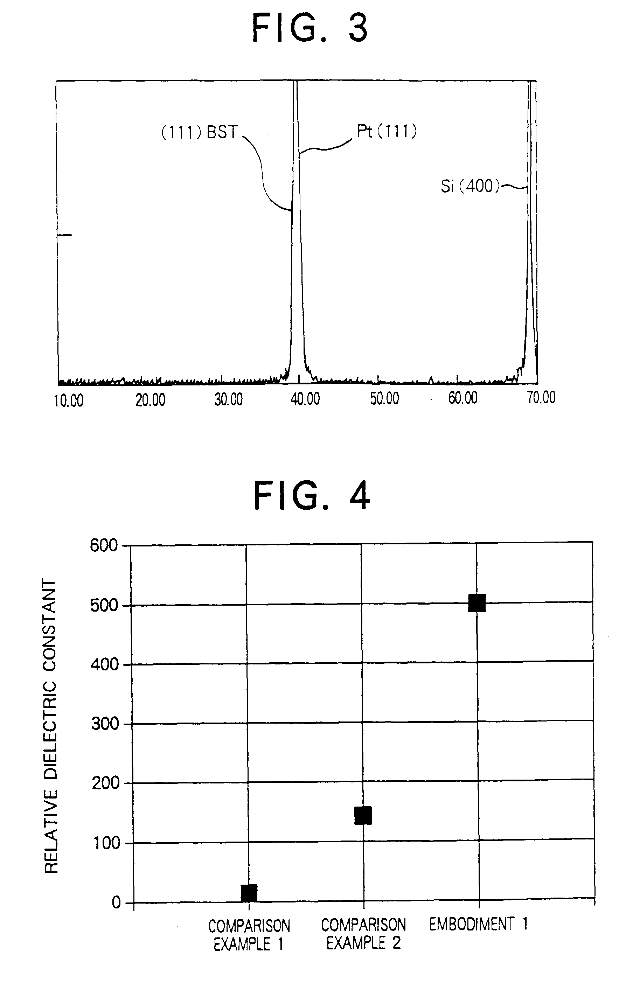

Fig. 3 shows measured results of an X-ray diffraction pattern of the BST thin film manufactured in this embodiment. In Fig. 3, a (111) peak of the BST thin film is observed in addition to a (400) peak of the silicon substrate and a (111) peak of the platinum film. It should be understood from these results that the BST thin film manufactured in this embodiment is crystallized with a perovskite structure and a single orientation (111).

A platinum (Pt) upper electrode 6 100 nm thick and 100 µm in diameter (⌀) is formed on the manufactured BST thin film 5 using a vacuum evaporation method. Then, the relative dielectric constant of the thin film is measured with an impedance analyzer by forming wiring between the platinum upper electrode 6 and a lower electrode composed of the titanium film 3 and the platinum film using a measuring frequency of 1 kHz and an applied voltage of ± 0. 1 V. Fig. 4 shows the measured results of the relative dielectric constant of the thin film which is a very large value of about 500.

In step 4 in Fig. 4, the heat treatment for thermally decomposing and removing organic substances in the dry gel thin film and simultaneously crystallizing the thin film is carried out at 550°C. However, if this temperature is set to range from 500 to 600°C and the other manufacturing conditions are similar to those in the above embodiment, it is possible to obtain a thin film of metal-oxide dielectric having a single orientation and a high dielectric constant.

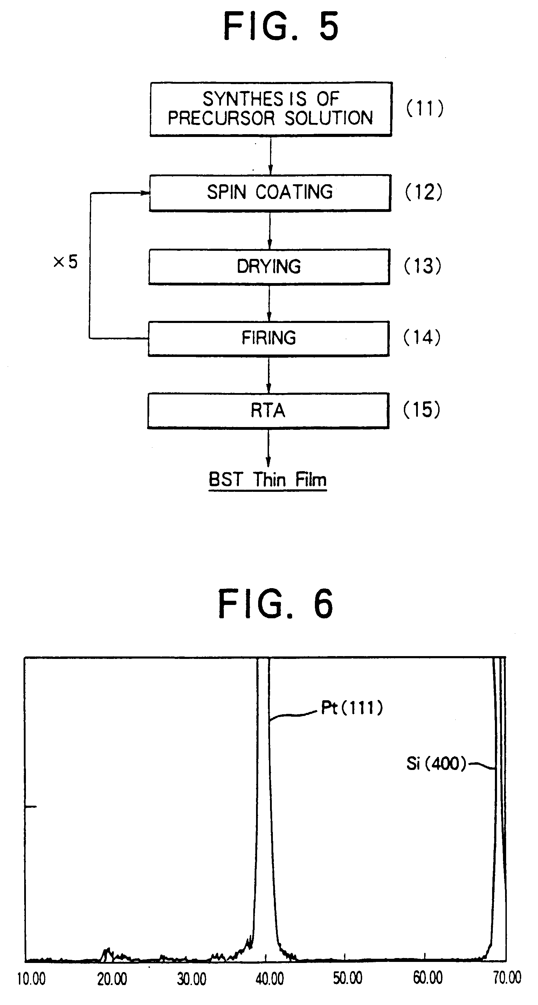

A BST thin film is manufactured as a Comparison Example by the procedure shown in Fig. 5. In this procedure, steps 11 to 13 are similar to steps 1 to 3 in the above embodiment. However, steps 14 and 15 are different from step 4 in the above embodiment. Accordingly, steps 14 and 15 only will be explained.

Dry gel is prepared by step 11 to step 13. Then, organic substances in the film of dry gel are thermally decomposed and are removed from the dry gel film. In step 14, this film is subjected to a heat treatment to fire it for 60 minutes at a temperature of 450°C and atmospheric pressure such that the film attains an amorphous state. Then, steps 12 to 14 are repeated five times so that a BST thin film 200 nm in thickness is manufactured. In the step 15, rapid thermal annealing (RTA) for crystallization is finally performed using an infrared rapid thermal annealing system. Two kinds of BST thin films are manufactured in two manufacturing conditions of the RTA. In a first manufacturing condition, the BST thin film is heated for 15 seconds at a temperature of 550°C under a 100% oxygen atmosphere at atmospheric pressure. In a second manufacturing condition, the BST thin film is heated for 15 seconds at a temperature of 650°C under a 100% oxygen atmosphere at atmospheric pressure. The BST thin film manufactured in the first manufacturing condition is shown in the Comparison Example 1. The BST thin film manufactured in the second manufacturing condition is shown in the Comparison Example 2.

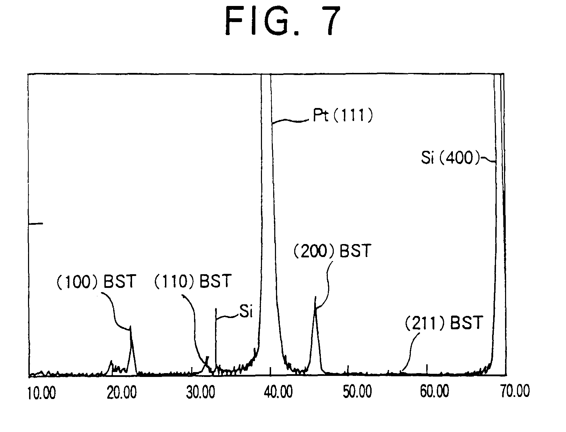

Fig. 6 shows the X-ray diffraction pattern of the BST thin film in the above Comparison Example 1. Fig. 7 shows the X-ray diffraction pattern of the BST thin film in the above Comparison Example 2. In Fig. 6, only the (400) peak of the silicon substrate and (111) peak of the platinum film are observed in Comparison Example 1 in which the RTA is performed at the temperature of 550°C. Accordingly, it should be understood that no BST thin film is crystallized in Comparison Example 1. In contrast, in Fig. 7, (100), (110), (200) and (211) peaks of the BST thin film are observed in addition to the (400) peak of the silicon substrate and the (111) peak of the platinum film in Comparison Example 2 in which RTA is performed at 650°C. Accordingly, it should be understood that the BST thin film in Comparison Example 2 is crystallized with a perovskite structure and random orientation.

Similar to the above embodiment, a platinum (Pt) upper electrode is formed on the BST thin film to measure the dielectric constant of the BST thin film in each of the Comparison Examples 1 and 2. The relative dielectric constant is measured under the same conditions as the above embodiment. Fig. 4 shows the results.

As shown in Fig. 4, the relative dielectric constant is about 13 in Comparison Example 1 and is about 160 in Comparison Example 2. When the above embodiment and these Comparison Examples are compared, it should be understood that the thin film of metal-oxide dielectric manufactured by the present invention has a very high dielectric constant.

In the above embodiment, a silicon substrate is used. However, the substrate is not limited to silicon. For example, a GaAs substrate can be used. When GaAs is used, a silicon nitride film is formed on the GaAs substrate. Similar to the above embodiment, a lower electrode is then formed on the silicon nitride film so that the thin film of BST dielectric can be formed by the present invention.

As mentioned above, in the manufacturing method of the present invention, thermal treatment is used for decomposing and removing organic substances in the dry gel thin film and simultaneously crystallizing the dry gel thin film. Therefore, it is possible to manufacture a thin film of metal-oxide dielectric having a single orientation and a high dielectric constant at a temperature equal to or lower than 600°C. Accordingly, the present invention can be applied to a manufacturing method of the thin film of metal-oxide dielectric in an element having a HBT structure, used in GaAsMMIC in which a film forming temperature equal to or lower than 600°C is required to maintain the characteristics of this element.

Further, the BST thin film can be also used as a material having a high dielectric constant. In a general manufacturing process of a semiconductor element of a highly integrated circuit, the temperature for forming a high dielectric constant thin film is high so that process sequences for forming a capacitor having a high dielectric constant are restricted. However, this problem can be solved by the present invention. In accordance with the present invention, the thin film having a high dielectric constant can be formed at a low temperature.

Accordingly, a greater degree of freedom in semiconductor design is achieved, and the manufacturing cost of the thin film can be reduced thereby reducing the cost of the semiconductor element.

## Claims

1. A method for manufacturing a thin film of a barium strontium titanate dielectric having a single orientation, the method comprising the steps of:
(a) preparing a precursor solution in a sol state containing component elements of materials of the barium strontium titanate;
(b) forming a thin film in a sol state from the precursor solution;
(c) drying the thin film in the sol state by removing residual moisture to form a thin film of dry gel;
(d) subjecting the dry gel thin film obtained in step (c) to a heat treatment at 500°C to 600°C thereby to thermally decompose and remove organic substances within the thin film in the gel state and simultaneously crystallise the dry gel thin film; and
(e) repeating steps (b) to (d) thereby to obtain a thin film of barium strontium titanate dielectric having a desired thickness and a single (111) orientation.

2. A method as claimed in claim 1, wherein the precursor solution contains barium diethoxide, strontium diethoxide and titanium tetraisopropoxide.

3. A method as claimed in claim 1 or claim 2, wherein the barium strontium titanate is of the formula (Ba_{0.7}Sr_{0.3})TiO₃.

4. A method as claimed in any preceding claim, wherein the thin film obtained in step (e) has a thickness of 200 nm.

5. A method as claimed in any preceding claim, wherein drying step (c) is carried out at a temperature of 100°C.

6. A method as claimed in claim 5, wherein drying step (c) is carried out for ten minutes.

## Patentansprüche

1. Verfahren zum Herstellen eines Dünnfilms eines Dielektrikums aus Bariumstrontiumtitanat mit einer einzelnen Ausrichtung, mit den folgenden Schritten:
(a) Herstellen einer Vorläuferlösung in einem Sol-Zustand, die Komponentenelemente von Materialien für das Bariumstrontiumtitanat enthält;
(b) Herstellen eines Dünnfilms in einem Sol-Zustand aus der Vorläuferlösung;
(c) Trocknen des Dünnfilms im Sol-Zustand durch Entfernen von Restfeuchtigkeit zum Ausbilden eines Dünnfilms aus trockenem Gel;
(d) Unterziehen des im Schritt (c) erhaltenen trockenen Gel-Dünnfilms einer Wärmebehandlung bei 500°C bis 600°C zum thermischen Zersetzen und Entfernen organischer Substanzen innerhalb des Dünnfilms im Gel-Zustand und zum gleichzeitigen Kristallisieren des trockenen Gel-Dünnfilms; und
(e) Wiederholen der Schritte (b) bis (d), um dadurch einen Dünnfilm des Dielektrikums Bariumstrontiumtitanat mit gewünschter Dicke und der einzigen Ausrichtung (111) zu erhalten.

2. Verfahren nach Anspruch 1, bei dem die Vorläuferlösung Bariumdiethoxid, Strontiumdiethoxid und Titantetraisopropoxid enthält.

3. Verfahren nach Anspruch 1 oder 2, bei dem das Bariumstrontiumtitanat von der Formel (Ba_{0,7}Sr_{0,3})TiO₃ ist.

4. Verfahren nach einem der vorstehenden Ansprüche, bei dem der im Schritt (e) erhaltene Dünnfilm eine Dicke von 200 nm aufweist.

5. Verfahren nach einem der vorstehenden Ansprüche, bei dem der Trocknungsschritt (c) bei einer Temperatur von 100°C ausgeführt wird.

6. Verfahren nach Anspruch 5, bei dem der Trocknungsschritt (c) für 10 Minuten ausgeführt wird.

## Revendications

1. Procédé de fabrication d'une couche mince d'un diélectrique de titanate de baryum et de strontium ayant une orientation unique, le procédé comprenant les étapes consistant :
(a) à préparer une solution de précurseur à l'état de sol contenant des éléments constituants de matériaux de titanate de baryum et de strontium,
(b) à former une couche mince à l'état de sol à partir de la solution de précurseur,
(c) à sécher la couche mince à l'état de sol en éliminant l'humidité résiduelle pour former une couche mince de gel sec,
(d) à soumettre la couche mince de gel sec obtenue à l'étape (c) à un traitement thermique à 500 - 600°C pour ainsi décomposer thermiquement et éliminer les substances organiques présentes dans la couche mince à l'état de gel et cristalliser simultanément la couche mince de gel sec, et
(e) à répéter les étapes (b) à (d) pour obtenir ainsi une couche mince de diélectrique de titanate de baryum et de strontium ayant une épaisseur souhaitée et une orientation unique (111).

2. Procédé selon la revendication 1, dans lequel la solution de précurseur contient du diéthylate de baryum, du diéthylate de strontium et du tétraisopropylate de titane.

3. Procédé selon la revendication 1 ou 2, dans lequel le titanate de baryum et de strontium a pour formule (Ba_{0,7}Sr_{0,3})TiO₃.

4. Procédé selon l'une quelconque des revendications précédentes, dans lequel la couche mince obtenue à l'étape (e) a une épaisseur de 200 nm.

5. Procédé selon l'une quelconque des revendications précédentes, dans lequel l'étape de séchage (c) est effectuée à une température de 100°C.

6. Procédé selon la revendication 5, dans lequel l'étape de séchage (c) est effectuée pendant 10 minutes.
